# EUROPEAN PATENT APPLICATION

(11) **EP 2 590 227 A1**
(43) Date of publication of application: **08.05.2013**
(21) Application number: 11800884.6
(22) Date of filing: 29.06.2011
(51) Int. Cl.: H01L 31/042

(54) **METHOD FOR MANUFACTURING SOLAR CELL MODULE, AND SOLAR CELL MODULE MANUFACTURED BY THE METHOD**

(30) Priority: 30.06.2010 JP 2010149308
(71) Applicant: Sharp Kabushiki Kaisha, Osaka-shi, Osaka 545-8522 (JP)
(72) Inventor: OBINATA, Ryosuke, Osaka-shi, Osaka 545-8522 (JP); HORINAKA, Hajime, Osaka-shi, Osaka 545-8522 (JP); MIZUO, Kazuhiro, Osaka-shi, Osaka 545-8522 (JP)
(74) Representative: Müller - Hoffmann & Partner
(86) International application number: PCT/JP2011/064892
(87) International publication number: WO 2012/002422

(57) **Abstract**

A method for manufacturing a solar battery module according to the present invention includes the steps of forming a solar battery cell (25) on a front-side insulation substrate (22), disposing a sealing member (24) on the front-side insulation substrate (22) on which the solar battery cell (25) is formed, the sealing member (24) having a shape smaller than outer shapes of the front-side insulation substrate (22) and a back-side insulation substrate (23) and having an uneven shape on a side that faces the solar battery cell (25), disposing the back-side insulation substrate (23) on the sealing member (24), sealing the solar battery cell (25) between the front-side insulation substrate (22) and the back-side insulation substrate (23) by applying heat under pressure from above the back-side insulation substrate (23) in vacuum conditions so as to squeeze the uneven portion of the sealing member (24) and bring the sealing member into intimate contact with the solar battery cell (25), and cooling and thereby hardening the sealing member. The sealing member is an ionomer resin.

## Description

### Technical Field

The present invention relates to a method for manufacturing a resin sealing type solar battery module having a laminated glass structure, and a solar battery module manufactured by the manufacturing method.

### Background Art

Solar battery modules have a variety of structures depending on their application, usage environment, and the like. One example of the solar battery modules is a solar battery module having a laminated glass structure. This solar battery module is configured such that multiple solar battery cells that are electrically connected to one another are sandwiched between a front-side glass substrate and a back-side glass substrate and are thereby sealed within the module.

Examples of prior art documents that disclose such solar battery modules having laminated glass structures include JP 2004-288677A (hereinafter, "Patent Document 1") and JP H11-31834A (hereinafter, "Patent Document 2").

In the solar battery module with a laminated glass structure disclosed in Patent Document 1, solar battery cells are sealed with a translucent resin sealing layer, and then the solar battery cells sealed with the translucent resin sealing layer are inserted and disposed in a sub-assembly constituted by a front-side glass substrate and a back-side glass substrate so as to be integrated into a single module.

In the solar battery module with a laminated glass structure disclosed in Patent Document 2, a sealing portion is formed between two glass substrates, and solar battery cells are disposed in the sealing portion and sealed with a filling material.

Below is a description of a method for sealing a solar battery module having a laminated glass structure.

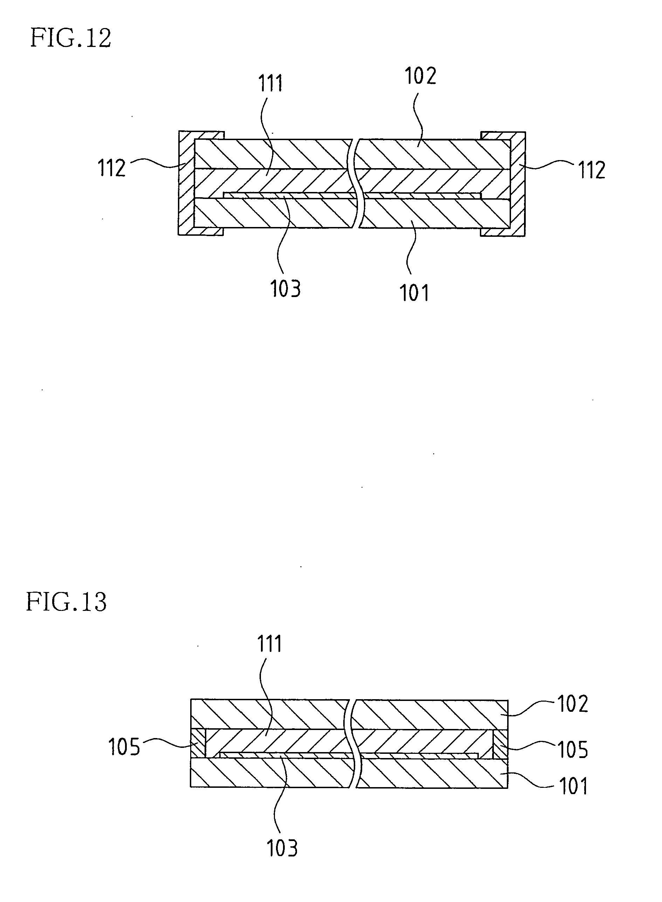

FIG. 12 is a schematic cross-sectional view showing an example of a configuration of a solar battery cell in which a resin is filled in a sealing portion between two glass substrates. As shown in FIG. 12, a solar battery cell 103 is formed on the upper face of a front-side glass substrate 101. The solar battery cell 103 is configured by laminating a front-side electrode layer, a photoelectric conversion layer, and a back-side electrode layer in this order. In this state, a back-side glass substrate 102 is disposed so as to face the front-side glass substrate 101, and a resin member 111 is filled in between the front-side glass substrate 101 and the back-side glass substrate 102 so as to cover the solar battery cell 103. Thereafter, a frame 112 for water proof is attached to the side faces of the front-side glass substrate 101 and the back-side glass substrate102, as a result of which the solar battery cell 103 is sealed. Here, the front-side glass substrate 101 and the back-side glass substrate102 have substantially the same thickness that ensures sufficient strength during lamination and even after modularization.

FIG. 13 is a schematic cross-sectional view showing another example of the configuration of a solar battery cell in which a resin is filled in a sealing portion between two glass substrates. As shown in FIG. 13, a solar battery cell 103 is formed on the upper face of a front-side glass substrate 101. In this state, a peripheral sealing member 105 is disposed on the upper face of the front-side glass substrate 101 so as to surround the solar battery cell 103, and a back-side plate glass 102 is disposed so as to face the front-side glass substrate 101. Thereafter, a resin member 111 is filled in a sealing portion that is formed and surrounded by the front-side glass substrate 101, the back-side plate glass 102, and the peripheral sealing member 105.

When the solar battery cell 103 is sealed with the frame 112 from outside the front-side glass substrate 101 and the back-side glass substrate102 as shown in FIG. 12, there is a problem in that the size of the solar battery module increases. On the other hand, in the process of sealing the solar battery cell of the solar battery module shown in FIG. 13, the step of filling the resin member 111 and the step of disposing the peripheral sealing member 105 are performed separately. For this reason, there is a problem in that the number of man-hours of operation increases.

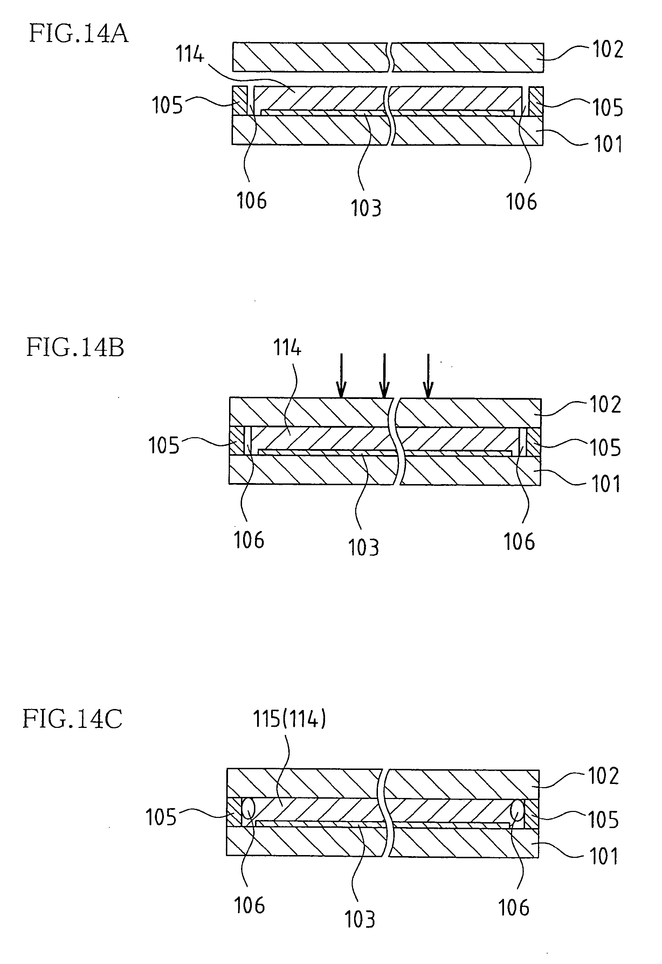

In view of this, in order to reduce the number of man-hours of operation, it is conceivable in the method for manufacturing a resin packing type solar battery module that the step of filling the resin member 111 and the step of disposing the peripheral sealing member 105 are included in the step of disposing the back-side glass substrate 102 facing the front-side glass substrate 101. FIG. 14A is a schematic cross-sectional view showing the step of laminating a resin member 114, a peripheral sealing member 105, and a back-side plate glass 102 on a front-side glass substrate 101, FIG. 14B is a schematic cross-sectional view showing a state during lamination processing, and FIG. 14C is a schematic cross-sectional view showing a state after lamination processing.

As shown in FIG. 14A, the resin member 114 and the peripheral sealing member 105 are disposed on the upper face of the front-side glass substrate 101 on which one or more solar battery cells 103 are formed, and the back-side glass substrate102 is disposed thereabove facing the front-side glass substrate 101.

Next, as shown in FIG. 14B, pressure and heat are applied in the direction indicated by arrows from above the back-side glass substrate 102 under vacuum conditions. As a result, air 106 in a sealing portion that is surrounded and formed by the front-side glass substrate 101, the back-side glass substrate 102, and the peripheral sealing member 105 is exhausted until the lower face of the back-side plate glass 102 comes in contact with the upper face of the peripheral sealing member 105. In this case, after the back-side glass substrate 102 have come in contact with the peripheral sealing member 105, the air 106 in the sealing portion cannot be sufficiently exhausted because there is no path through which the air 106 in the sealing portion is exhausted to the outside.

As a result of this exhaust processing, the heated resin member 114 makes a translucent resin layer 115 as shown in FIG. 14C. In the solar battery module manufactured by the above-described manufacturing method, the air 106 will remain intact in the sealing portion in the form of air bubbles. The air bubbles remaining in the sealing portion will be thermally expanded when the solar battery module is heated by sunlight, thus causing degradation such as cracking in the surrounding translucent resin layer 115. The degradation in the translucent resin layer 115 makes it difficult to maintain the performance of the solar battery cell 103.

### Prior Art Document

### Patent Document

- [Patent Document 1]: JP 2004-288677A
- [Patent Document 2]: JP H11-31834A

### Summary of Invention

### Problem to be Solved by the Invention

The above-described problem is caused by the fact that the air remains intact as air bubbles in the sealing portion. This problem can be solved by eliminating the peripheral sealing member 105 and instead increasing the outer dimensions of the resin member 114 so that the resin member 114 can serve also as a sealing member.

Incidentally, recent solar battery modules are becoming thinner and lighter. In order to reduce the thickness of solar battery modules, reducing the thicknesses of either the front- or the back-side glass substrate and the resin member 114 is being considered. When reducing the thickness of glass, it is possible by reducing the thickness of glass on only one side to reduce weight while maintaining strength. Furthermore, reducing the thickness of the front-side glass is more effective because the front-side glass can be replaced with low-cost blue glass or the like without degrading transmittance.

However, the inventors of the present invention have noticed the following issues when considering the reduction in the thickness of the front-side glass and the elimination of the peripheral sealing member in order to reduce the thickness of a solar battery module.

Although not shown, a drawing line for drawing current and a lead for outputting current from the drawing line to the exterior are disposed on a back-side electrode layer of the solar battery cell 103, and a junction portion between the drawing line and the lead projects by the amount of thickness of the drawing line and the lead from the back-side electrode layer. Thus, when heat is applied under pressure from above the back-side glass substrate during lamination processing, stress is first concentrated on corner portions of the drawing line and the lead, and in particular, great stress is imposed on the junction portion when the resin member 114 is squeezed and extended in the planar direction, because the peripheral sealing member 105 has been eliminated. Such stress greatly affects the thickness-reduced front-side glass substrate (or thickness-reduced back-side glass substrate) and causes a problem in that cracking in the thickness-reduced front-side glass substrate (or thickness-reduced back-side glass substrate) or the like is likely to occur in the periphery of the corner portions of or the junction portion between the drawing line and the lead.

In order to eliminate the peripheral sealing member 105 and cause the resin member 114 to serve also as a sealing member, it is necessary to reliably seal the peripheral end face of the solar battery module with the edge portion of the resin member 114 in order to prevent water vapors or the like from entering the solar battery module from the peripheral end face of the module. This brings up an issue that it is necessary to devise the position at which the end face of the resin member 114 is formed, the shape of the end face, and the like.

The present invention has been conceived in order to solve the above-described problems, and it is an object of the present invention to provide a method for manufacturing a resin sealing type solar battery module having a laminated glass structure, the method causing less breakage in a front-side glass substrate, a back-side glass substrate, or the like and exhibiting excellent water resistance even if the thickness-reduced front-side glass substrate (or thickness-reduced back-side glass substrate) is employed in order to reduce the thickness and weight of the solar battery module, and to provide a solar battery module manufactured by the manufacturing method.

### Means for Solving the Problems

In order to solve the above-described problems, a method of the present invention for manufacturing a solar battery module having a laminated glass structure in which an insulation substrate on one side has a reduced thickness, includes the steps of forming a solar battery cell on a front-side insulation substrate, disposing a sealing member on the front-side insulation substrate on which the solar battery cell is formed, the sealing member having a shape smaller than outer shapes of the front-side insulation substrate and a back-side insulation substrate and having an uneven shape on a side that faces the solar battery cell, disposing the back-side insulation substrate on the sealing member, sealing the solar battery cell between the front-side insulation substrate and the back-side insulation substrate by applying heat under pressure from above the back-side insulation substrate in vacuum conditions so as to squeeze the uneven portion of the sealing member and bring the sealing member into intimate contact with the solar battery cell, and cooling and thereby hardening the sealing member. The sealing member is an ionomer resin.

According to the method of the present invention for manufacturing a solar battery module having a laminated glass structure in which an insulation substrate on one side has a reduced thickness, the sealing member having a shape smaller than the outer shapes of the back-side insulation substrate and the front-side insulation substrate and having an uneven shape on the side that faces the back-side electrode layer of the solar battery cell is disposed on the front-side insulation substrate on which the solar battery cell is formed, and the solar battery cell is sealed between the front-side insulation substrate and the back-side insulation substrate by applying heat under pressure from above the back-side insulation substrate in vacuum conditions so as to squeeze the uneven portion of the sealing member and bring the sealing member into intimate contact with the solar battery cell. In this case, by forming the sealing member of an ionomer resin, it is easy to deform the sealing member that has been molten by heating and it is possible to substantially evenly squeeze the uneven portion by extending it in the planar direction. Eventually, the uneven portion is totally squeezed and the sealing member equally comes in intimate contact with the entire back-side electrode layer of the solar battery cell and the peripheral upper face of the front-side insulation substrate that lies off the solar battery cell. In this lamination step (lamination processing), since the uneven portion of the sealing member is substantially evenly squeezed when pressure is applied to the sealing member via the back-side insulation substrate, the resultant stress is substantially evenly imposed on the entire of the back-side insulation substrate and the front-side insulation substrate and will not be concentrated on specific sites. Thus, it is possible to prevent or reduce damage such as cracking in the thickness-reduced insulation substrate or the like.

According to the method of the present invention for manufacturing a solar battery module, the sealing member may be formed such that after hardening, a peripheral end face of the sealing member is flush with or projects out from peripheral end faces of the front-side insulation substrate and the back-side insulation substrate.

With this configuration, the sealing member can also serve to seal the peripheral end face of the solar battery module. As a result, there is no need to individually provide a sealing member that seals the solar battery cell and a sealing member that seals the peripheral end face of the solar battery module (e.g., a frame body made of aluminum or the like) as in conventional technology, and it is possible to reduce the number of components and to omit the step of sealing the peripheral end face of the solar battery module from the assembly process.

By the sealing member serving also to seal the peripheral end face of the solar battery module, it is also possible to omit the step of cutting a portion of the sealing member that lies off the module as in conventional technology.

Furthermore, if the peripheral end face of the sealing member is formed so as to project out from the peripheral end faces of the front-side insulation substrate and the back-side insulation substrate, even if a foreign object hits the edge of the solar battery module during or after installation of the module, this object will first hit the sealing member, and thus the sealing member can serve as a cushioning material and reduce damage to the solar battery module.

Moreover, if the peripheral end face of the sealing member is formed flush with or projecting slightly out from the peripheral end faces of the front-side insulation substrate and the back-side insulation substrate, it is possible to prevent the sealing member deformed in gel from dripping from the peripheral end faces of the front-side insulation substrate and the back-side insulation substrate and adhering to a laminating device during manufacture of the solar battery module.

According to the method of the present invention for manufacturing a solar battery module, a drawing line for drawing current and a lead for outputting current from the drawing line to an exterior may be disposed on the back-side electrode layer of the solar battery cell, and the sealing member in a portion that faces a junction portion between the drawing line and the lead may be formed thinner than in the other portion.

The junction portion between the drawing line and the lead projects by the amount of thickness of the drawing line and the lead from the back-side electrode layer. Accordingly, in the manufacturing method of the present invention, the thickness of the sealing member in a portion that includes the junction portion and the periphery thereof is reduced to be smaller than the thickness of the sealing member in the other portion. As a result, it is possible to reduce and disperse stress that is imposed on the sealing member by the junction portion when the sealing member comes in intimate contact with the back-side electrode layer of the solar battery cell.

According to the method of the present invention for manufacturing a solar battery module, the lead may be formed so as to have a smaller thickness in the junction portion than in the other portion.

As described above, the junction portion between the drawing line and the lead projects by the amount of thickness of the drawing line and the lead from the back-side electrode layer. Thus, in the manufacturing method of the present invention, the thickness of the junction portion is reduced to be as small as possible by forming the lead so as to have a smaller thickness in the junction portion than in the other portion. As a result, it is possible to reduce and disperse stress that is imposed on the sealing member by the junction portion when the sealing member comes in intimate contact with the back-side electrode layer of the solar battery cell.

Furthermore, by reducing the thickness of the sealing member in a peripheral portion that includes the junction portion in addition to reducing the thickness of the lead, it is possible to further reduce and disperse stress that is imposed on the sealing member when the sealing member comes in intimate contact with the back-side electrode layer of the solar battery cell.

According to the method of the present invention for manufacturing a solar battery module, it is preferable that the lead is formed so as to have a greater width in the junction portion than in the other portion.

According to the method of the present invention for manufacturing a solar battery module, it is preferable that the thickness and width of the lead are set such that the cross-sectional area of the lead along the width in the junction portion is equal to the cross-sectional area of the lead along the width in the other portion.

According to the method of the present invention for manufacturing a solar battery module, in the cross-sectional shape of the lead and/or the drawing line along the width thereof, a corner portion or the entire of the lead and/or the drawing line along the width may be formed in a curved shape.

Since the corner portion or the entire of the lead and/or the drawing line is formed in a curved shape in the cross-sectional shape thereof along the width, it is possible avoid a situation in which stress is concentrated on specific sites of the lead and/or the drawing line and to disperse the stress.

A solar battery module according to the present invention has a laminated glass structure in which an insulation substrate on one side has a reduced thickness and is configured such that a solar battery cell is formed on a front-side insulation substrate and a sealing member is disposed between the solar battery cell and a back-side insulation substrate. The vicinity of a peripheral edge portion of the thinner insulation substrate is curved toward the thicker insulation substrate.

In the solar battery module of the present invention, when the solar battery cell is sealed with the sealing member, the uneven portion of the sealing member is squeezed so that the sealing member is brought into intimate contact with the back-side electrode layer of the solar battery cell. Thus, during sealing, local stress will not be imposed on the front-side insulation substrate and the back-side insulation substrate including the back-side electrode layer of the solar battery cell. Accordingly, it is possible to provide a solar battery module having a laminated structure that does not cause breakage in the front-side insulation substrate and the back-side insulation substrate.

In the solar battery module of the present invention, the insulation substrate on one side has a reduced thickness. Also, since the solar battery module has outer dimensions of approximately 1400 mm vertically and 1000 mm horizontally and is large in scale, the dimensions of the front-side insulation substrate and the back-side insulation substrate also conform to these outer dimensions. By reducing the thickness of the insulation substrate on one side in such a large-scale solar battery module, that insulation substrate itself becomes easy to curve. Thus, using this characteristic of the insulation substrate, the vicinity of the peripheral edge portion of the thinner insulation substrate is formed so as to be curved toward the thicker insulation substrate when the solar battery cell is sealed with the sealing member between the front-side insulation substrate and the back-side insulation substrate. Forming the insulation substrates in this way reduces a gap between the peripheral edge portions of the front-side insulation substrate and the back-side insulation substrate, thus making it possible to reduce the area of the peripheral edge of the sealing member that is exposed to the peripheral edge portion of the solar battery module. As a result, it is possible to more effectively prevent the entry of water vapor or the like from the peripheral end face of the solar battery module after installation of the solar battery module.

### Effects of the Invention

According to the present invention, when the solar battery cell is laminated and sealed with the sealing member that is formed of an ionomer resin having high fluidity, the uneven portion of the sealing member is squeezed so that the sealing member is brought into intimate contact with the back-side electrode layer of the solar battery cell. Thus, during sealing, local stress will not be imposed on the front-side insulation substrate and the back-side insulation substrate including the back-side electrode layer of the solar battery cell. Accordingly, it is possible to prevent breakage in the front-side insulation substrate and the back-side insulation substrate due to local stress applied when the solar battery cell is sealed with the sealing member.

### Brief Description of Drawings

[FIG. 1] FIG. 1 is a perspective view showing an overall configuration of a solar battery system in which solar battery modules are placed on a mounting.
[FIG. 2] FIG. 2 is a perspective view of a solar battery module, viewed from the front (light-receiving face) side.
[FIG. 3] FIG. 3 is a perspective view of the solar battery module, viewed from the back side opposite the front side.
[FIG. 4] FIG. 4 is an exploded perspective view of the solar battery module, viewed from the back side.
[FIG. 5A] FIG. 5A is a perspective view showing a more specific exemplary configuration of the solar battery module and illustrating one scene in the manufacturing process.
[FIG. 5B] FIG. 5B is a perspective view showing a more specific exemplary configuration of the solar battery module and illustrating one scene in the manufacturing process.
[FIG. 6] FIG. 6 is a cross-sectional view taken along line D-D in FIG. 5B.
[FIG. 7A] FIG. 7A is a schematic cross-sectional view of the solar battery module before lamination processing, taken along line E-E in FIG. 5B.
[FIG. 7B] FIG. 7B is a schematic cross-sectional view of the solar battery module after lamination processing, taken along line E-E in FIG. 5B.
[FIG. 8A] FIG. 8A is a schematic cross-sectional view of a solar battery module before lamination processing, taken along line E-E in FIG. 5B, the solar battery module employing a sealing resin according to a variation.
[FIG. 8B] FIG. 8B is a schematic cross-sectional view of a solar battery module after lamination processing, taken along line E-E in FIG. 5B, the solar battery module employing the sealing resin according to the variation.
[FIG. 9A] FIG. 9A is a schematic cross-sectional view of a solar battery module before lamination processing, taken along line E-E in FIG. 5B, the solar battery module employing a lead according to Variation 1.
[FIG. 9B] FIG. 9B is a schematic cross-sectional view of a solar battery module after lamination processing, taken along line E-E in FIG. 5B, the solar battery module employing the lead according to Variation 1.
[FIG. 10A] FIG. 10A is a schematic cross-sectional view of a solar battery module before lamination processing, taken along line E-E in FIG. 5B, the solar battery module employing a lead according to Variation 2.
[FIG. 10B] FIG. 10B is a schematic cross-sectional view of a solar battery module after lamination processing, taken along line E-E in FIG. 5B, the solar battery module employing the lead according to Variation 2.
[FIG. 11] FIG. 11 is a schematic cross-sectional view of a solar battery module according to a variation of a front-side glass substrate, taken along line E-E in FIG. 5B.
[FIG. 12] FIG. 12 is a schematic cross-sectional view showing an example of the configuration of a conventional solar battery cell in which a resin is filled in a sealing portion between two glass substrates.
[FIG. 13] FIG. 13 is a schematic cross-sectional view showing another example of the configuration of a conventional solar battery cell in which a resin is filled in a sealing portion between two glass substrates.
[FIG. 14A] FIG. 14A is a schematic cross-sectional view showing a step of laminating a resin member, a peripheral sealing member, and a back-side plate glass on a front-side glass substrate.
[FIG. 14B] FIG. 14B is a schematic cross-sectional view showing a state during lamination processing.
[FIG. 14C] FIG. 14C is a schematic cross-sectional view showing a state after lamination processing.

### Mode for Carrying out the Invention

Hereinafter, embodiments of the present invention will be described with reference to the drawings.

The present embodiment describes a case in which a solar battery module manufactured by the manufacturing method of the present invention is applied to a photovoltaic power generating system that uses the solar battery module placed on a mounting.

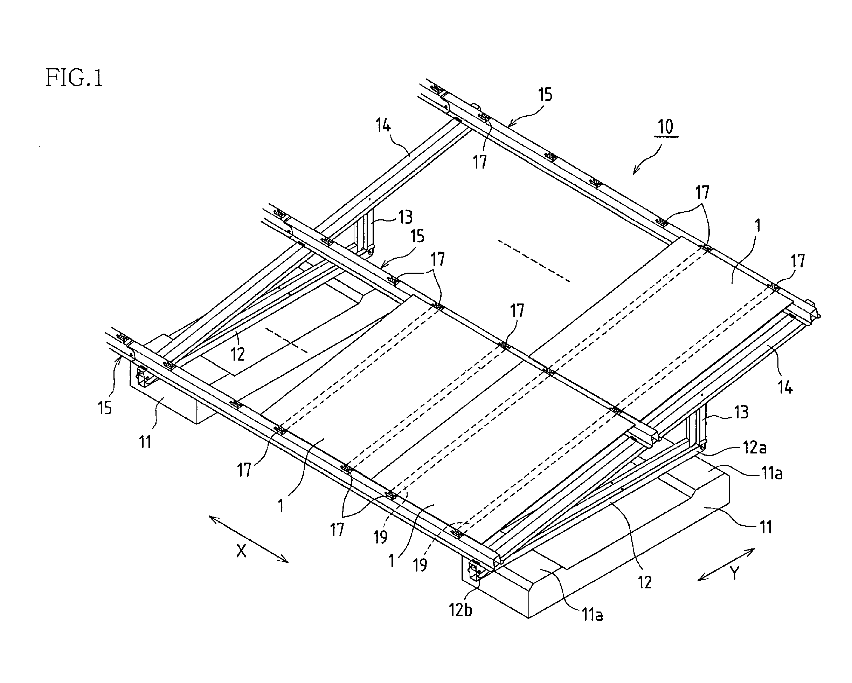

FIG. 1 is a perspective view showing an overall configuration of a solar battery system in which a plurality of solar battery modules 1 manufactured by the manufacturing method of the present invention are placed on a mounting 10.

The photovoltaic power generating system of the present embodiment provides a structure that can be used in, for example, a power plant, and the mounting 10 is roughly constituted by concrete foundations 11, base bars 12, arms 13, longitudinal bars 14, and lateral bars 15.

Specifically, the plurality of concrete foundations 11 are built at equal intervals on the ground, and each base bar 12 is fixed on an upper face 11a of each concrete foundation 11 so that the base bars 12 are aligned at equal intervals. Then, an arm 13 is connected upright to a back end portion 12a of each base bar 12, and a longitudinal bar 14 is fixed to and thereby runs diagonally between a tip end portion 12b of each base bar 12 and an upper end portion of each arm 13. Furthermore, three lateral bars 15 are disposed orthogonal to the longitudinal bars 14 so that the lateral bars 15 are aligned on the longitudinal bars 14. In other words, the lateral bars 15 are disposed at different levels along the inclination of the longitudinal bars 14, and the opposite end portions of solar battery modules 1 are put on each pair of adjacent lateral bars 15 so that the solar battery modules 1 are placed at an angle, running between the pair of lateral bars 15. Then, guide support members 17 are attached to predetermined locations on each lateral bar 15 so that the opposite ends of the solar battery module 1 are supported and fixed by the guide support members 17.

In the photovoltaic power generating system with this configuration, a plurality of solar battery modules 1 are placed laterally in a row between a lower lateral bar 15 and a middle lateral bar 15, and a plurality of solar battery modules 1 are placed laterally in a row between the middle lateral bar 15 and an upper lateral bar 15. In other words, the plurality of solar battery modules 1 are placed in two rows, namely, upper and lower rows, on the three lateral bars 15. Also, three solar battery modules 1 in the lower row and three solar battery modules 1 in the upper row are placed between a pair of adjacent left and right longitudinal bars 14.

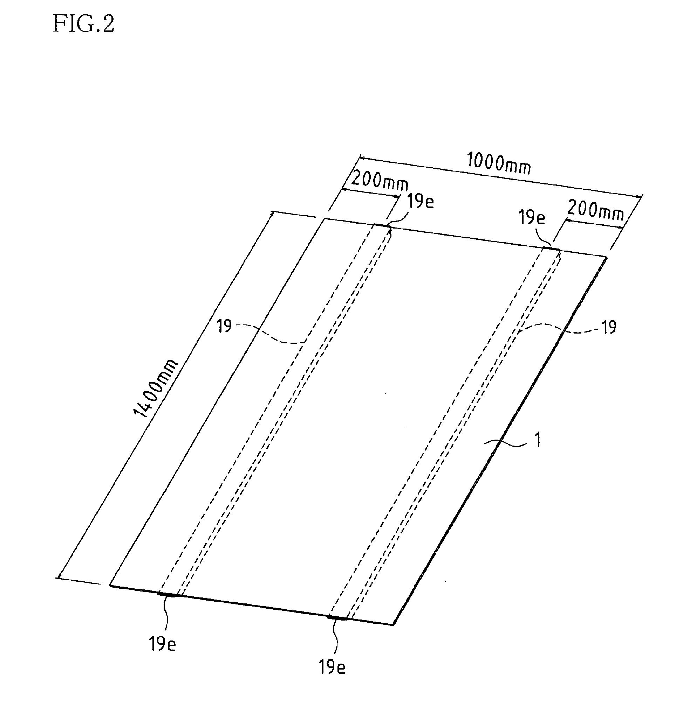

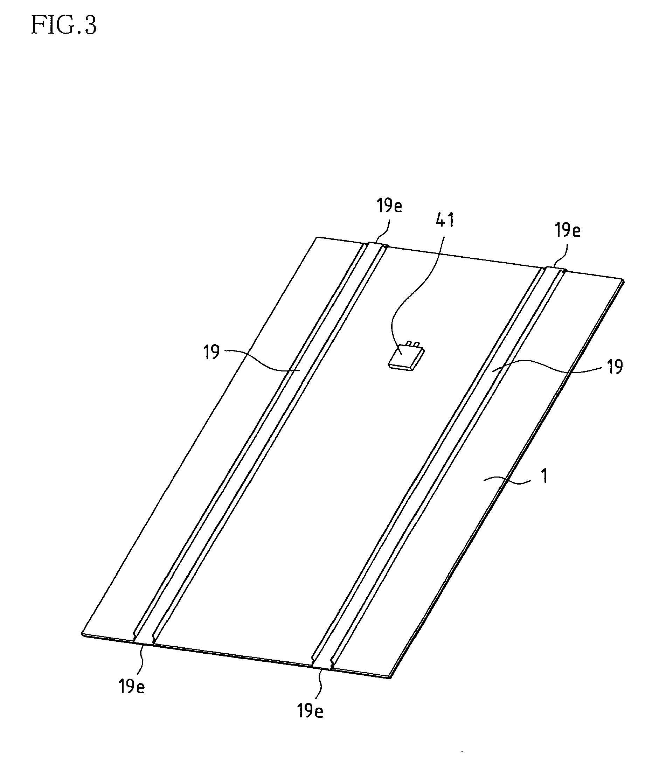

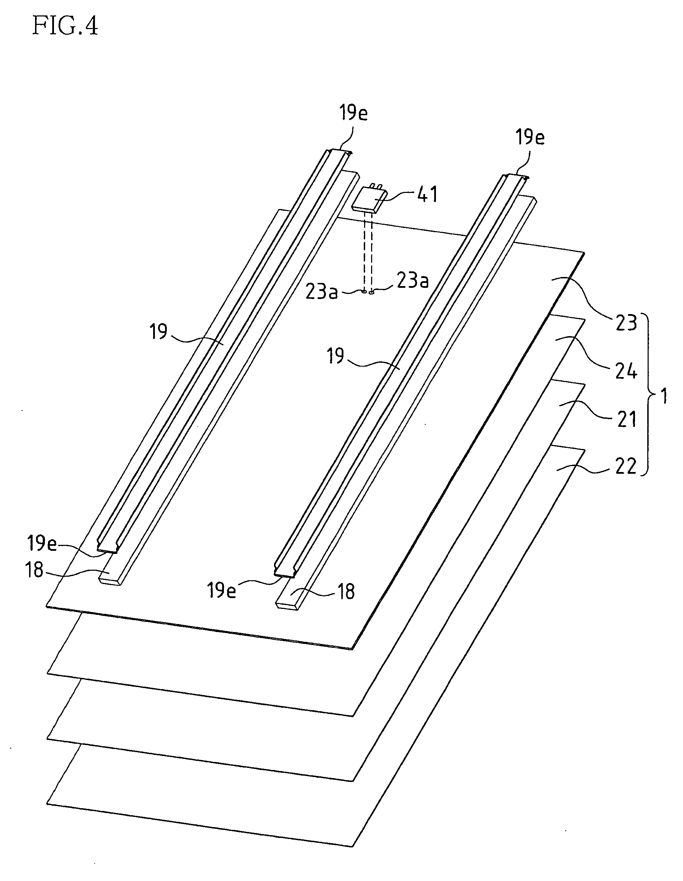

FIGS. 2 through 4 show the configuration of a solar battery module 1 according to the present embodiment. FIG. 2 is a perspective view thereof viewed from the front side (light-receiving face side), FIG. 3 is a perspective view thereof viewed from the back side opposite the front side, and FIG. 4 is an exploded perspective view thereof viewed from the back side.

The solar battery module 1 of the present embodiment provides a structure that include two support members 19 that serve also as mounting brackets to be attached to the mounting 10.

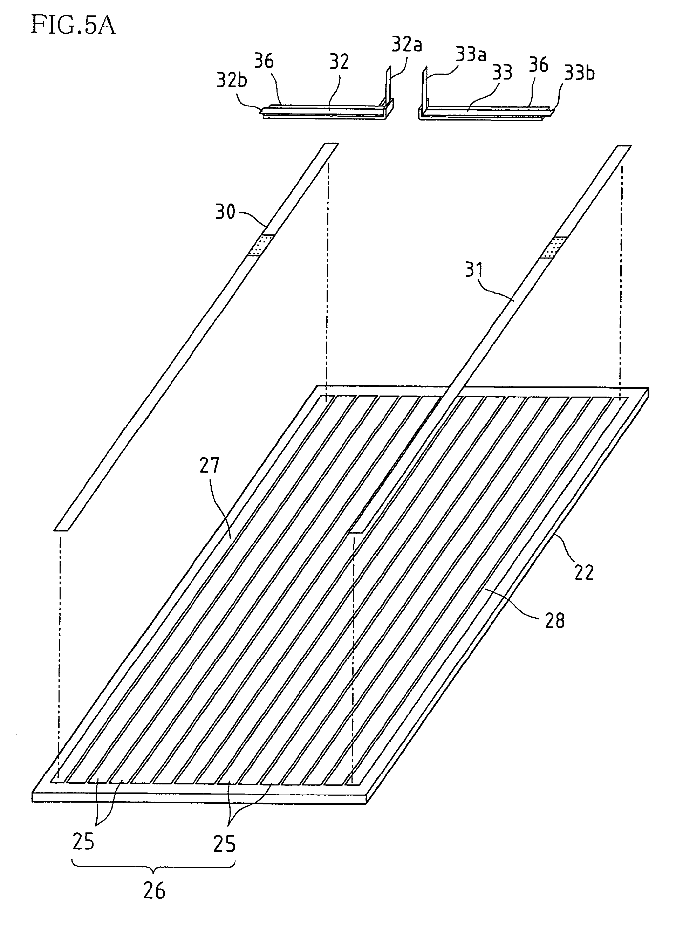

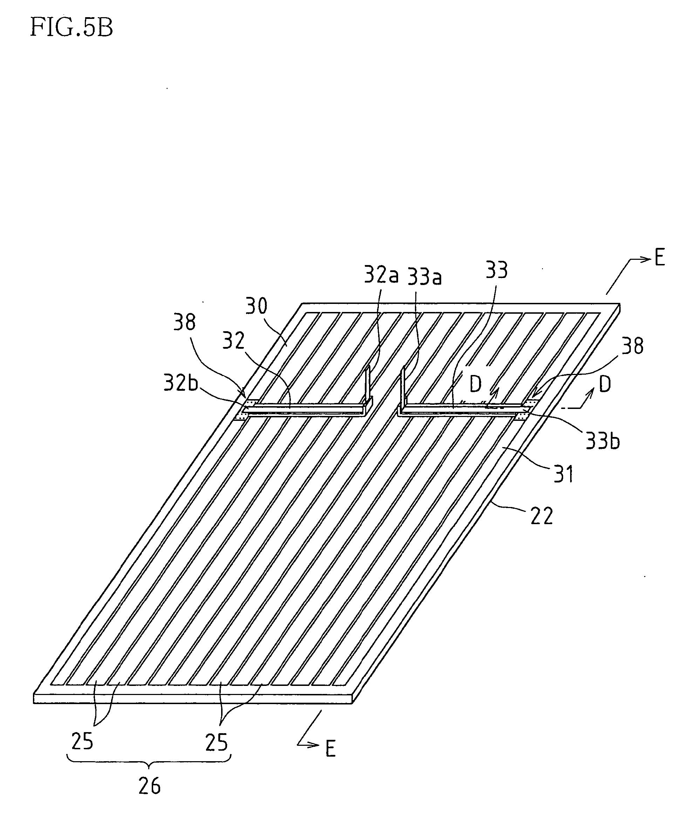

The solar battery module 1 has a laminated glass structure as shown in FIG. 4 in which a semiconductor layer portion 21 constituted by a plurality of solar battery cells 25 (see FIGS. 5A and 5B) is in between a front-side (light-receiving face side) glass substrate 22 and a back-side glass substrate 23. The long support members 19 formed in a shape that enables mounting of the solar battery module I on the mounting 10 are disposed and fixed on the surface of the back-side glass substrate 23 along the length of the solar battery module 1. Also, a sealing member 24, which will be described later, is placed between the back-side glass substrate 23 and the semiconductor layer portion 21.

L-shaped engaging portions 19e that are each bent upward are provided at opposite end portions of each of the support members 19, and these engaging portions 19e are engaged with the guide support members 17 of the mounting 10 so that the solar battery module 1 is supported by and fixed to the mounting 10. The two support members 19 are disposed in parallel at a predetermined interval in the lateral direction of the solar battery module 1. These support members 19 are disposed at positions that are spaced by a fixed distance inwardly from the sides of the module along the length thereof. Specifically, this solar battery module 1 has a rectangular shape of approximately 1400 mm longitudinally and approximately 1000 mm laterally in plan view, and each support member 19 is disposed at a position that is spaced approximately 200 mm inwardly from each side of the module along the length thereof (note that the distance is not limited to 200 mm). By disposing the two support members 19 in the lateral direction of the solar battery module 1 in this way, the solar battery module 1 can be stably placed and fixed on the mounting 10 without rattling in the lateral direction (X direction in FIG. 1). Disposing the support members 19 at positions that are spaced approximately 200 mm inwardly from the sides of the module makes it possible to achieve a well-balanced distribution of the weight of the solar battery module 1 on the support members 19.

The support members 19 are also fixedly bonded to the surface of the back-side glass substrate 23 of the solar battery module 1 with double-faced tapes 18 that each have an adhesive layer on both sides of a cushioning material. One example of the adhesive layer that can be used is an acrylic adhesive layer. As the cushioning material, polyolefin, acrylic rubber, or the like can be used. By using the double-faced tapes 18, each having the adhesive layer on both sides of the cushioning material, to fix the support members 19 to the back-side glass substrate 23 of the solar battery module 1 in this way, even if, for example, the support members 19 and the solar battery module 1 after installed on the mounting 10 undergo thermal contraction and expansion due to the influence of surrounding environments (e.g., temperature change), it is possible to mitigate stress that is imposed due to a difference in the thermal expansion coefficient at that time between the support members 19 and the solar battery module 1 (specifically, back-side glass substrate 23). In other words, it is possible to reduce load stress imposed on the solar battery module 1 and to prevent damage to the module such as cracking.

Reference numeral 41 shown in FIGS. 3 and 4 denotes a terminal box for drawing positive and negative leads (output leads) 32 and 33 (see FIG. 5A) from openings 23a of the back-side glass substrate 23 for electrical connection, the leads 32 and 33 being for outputting current from the semiconductor layer portion 21, which will be described later, to the exterior.

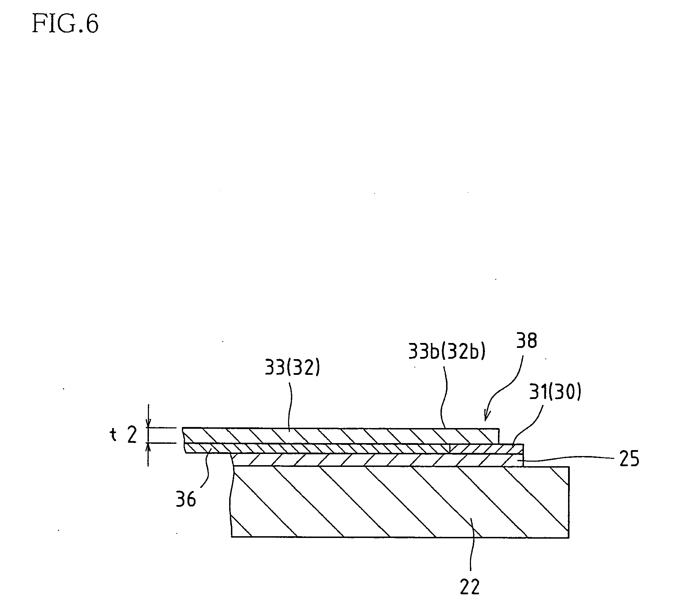

FIGS. 5A, 5B, and 6 show a more specific exemplary configuration of the solar battery module 1 according to the present embodiment. FIGS. 5A and 5B are perspective views of the module illustrating two scenes in the manufacturing process, and FIG. 6 is a cross-sectional view of the module taken along line D-D in FIG. 5B. Note that although FIG. 6 is a cross-sectional view of a junction portion 38 between a negative drawing line 31 and the negative lead 33, the same applies to a cross-sectional view of a junction portion between a positive drawing line 30 and the positive lead 32, and thus reference numerals that correspond to the positive drawing line 30 and the positive lead 32 are also indicated with parentheses.

The solar battery cells 25 are each formed by laminating a front-side electrode layer made of a transparent conductive film (TCO: Transparent Conductive Oxide), a photoelectric conversion layer, and an Ag back-side conducting layer serving as a back-side electrode layer, all of which are not shown, in this order on the front-side glass substrate 22, using a vacuum device or the like. Examples of the transparent electrode film also include SnO₂ and ZnO, in addition to ITO. Examples of the photoelectric conversion layer include silicon-based photoelectric conversion films made of amorphous silicon, microcrystalline silicon, or the like, and compound photoelectric conversion films made of CdTe, CuInSe₂, or the like.

The solar battery cells 25 configured in this way are each in the shape of a long and narrow strip as shown in FIG. 5A. Each pair of adjacent solar battery cells 25 are arranged such that the front-side electrode layer of one solar battery cell and the back-side electrode layer of the other are connected to each other, forming a solar battery string 26 in which the plurality of solar battery cells 25 are connected in series.

Specifically, in order to provide high voltage, the front-side electrode layer, the photoelectric conversion layer, and the back-side electrode layer are each partitioned as necessary with laser beams. Partitioning for forming several rows of a set of series-connected integrated cells is also implemented by laser beam machining, and the unit of a set of series-connected integrated cells obtained by this partitioning is referred to as the "solar battery string" as mentioned above.

Then, a P-type electrode terminal portion 27 is formed on the solar battery cell 25 located at one edge of the solar battery string 26, and an N-type electrode terminal portion 28 is formed on the edge portion of the back-side electrode layer of the solar battery cell 25 located at the other edge. These P- and N-type electrode terminal portions 27 and 28 serve as electrode drawing portions.

Also, the positive drawing line (positive current-collecting portion) 30 made of copper foil and having a thickness of approximately 120 µm, called a "bus bar", is electrically and mechanically bonded to the P-type electrode terminal portion 27, and the negative drawing line (negative current-collecting portion) 31 made of copper foil and having a thickness of approximately 120 µm, called a "bus bar", is electrically and mechanically bonded to the N-type electrode terminal portion 28. As a means for bonding these lines, solder, conductive paste (Ag paste), or the like can be used.

In the above-described configuration, the positive lead 32 and the negative lead 33, each being a flat cable with one side coated with an insulation film 36, are disposed in a straight line with their tip ends facing each other (or shifted in parallel along the width) on the solar battery string 26. FIGS. 5A and 5B illustrate the case in which the positive and negative leads are disposed in a straight line.

One end portion 32b of the positive lead 32 that is exposed is connected to the positive drawing line 30 by soldering. The other end portion of the positive lead 32 is located in approximately the center portion of the solar battery string 26 and forms an output lead portion 32a by being bent upright from the surface of the solar battery string 26 (e.g., in a direction perpendicular to that surface).

Similarly, one end portion 33b of the negative lead 33 that is exposed is connected to the negative drawing line 31 by soldering. The other end portion of the negative lead 33 is located in approximately the center portion of the solar battery string 26 and forms an output lead portion 33a by being bent upright from the surface of the solar battery string 26 (e.g., in a direction perpendicular to that surface).

Although the positive lead 32 and the negative lead 33 span the plurality of solar battery cells 25, they will not cause short circuiting of the solar battery cells 25 because one sides of the leads 32 and 33 (surfaces thereof on the side in contact with the solar battery cells 25) are coated with the insulation film 36.

Note that the solar battery cells 25 are not limited to thin-film solar battery cells, and may be crystal-system solar battery cells formed from a wafer.

Examples of the front-side glass substrate 22 and the back-side glass substrate 23 that can be used include soda-lime glass, superwhite glass, figured glass, tempered glass, double tempered glass, and wired glass. The front-side glass substrate 22 and the back-side glass substrate 23 do not necessarily have to be of the same type, and different types of glass substrates may be used for the front- and back-side glass substrates. The type of each glass substrate to be used can be appropriately selected in consideration of factors such as surrounding environments where the solar battery module 1 is installed. The front-side glass substrate 22 disposed on the light-receiving face side of the solar battery module 1 is formed of a glass substrate having translucency.

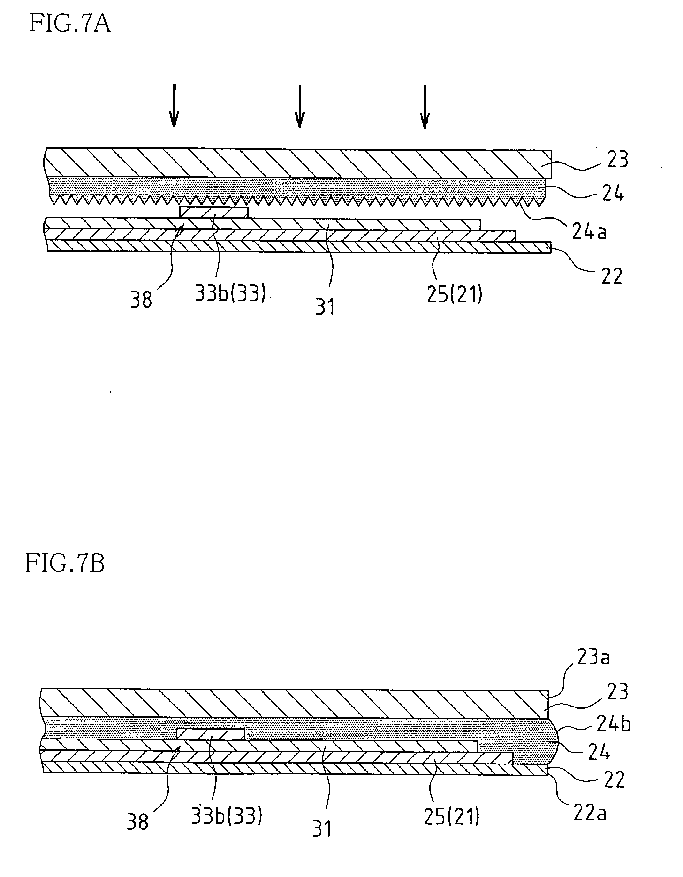

FIGS. 7A and 7B are schematic cross-sectional views of the solar battery module 1 of the present embodiment, taken along line E-E in FIG. 5B. FIG. 7A shows a state of the module before made into a final form (i.e., before lamination processing), and FIG. 7B shows a state of the module as a final article (i.e., after the lamination processing). In FIGS. 7A and 7B, the front-side glass substrate 22 is shown on the bottom side and the back-side glass substrate 23 is shown on the top side. In other words, the solar battery module 1 is shown upside down. Accordingly, although the solar battery module 1 is inverted when actually used as a product, the following description of the solar battery module 1 of the present embodiment is given in accordance with the top and bottom in FIGS. 7A and 7B.

The solar battery module 1 of the present embodiment is configured such that the plurality of solar battery cells 25 forming the semiconductor layer portion 21 are disposed on the front-side glass substrate 22, and the back-side glass substrate 23 is disposed on the solar battery cells 25 via the sealing member 24. In the solar battery module 1 of the present embodiment, the front-side glass substrate 22 is formed thinner than the back-side glass substrate 23. As a specific example, in the case of using glass substrates each having outer dimensions of approximately 1400 mm longitudinally and 1000 mm laterally, the thickness of the front-side glass substrate 22 is 0.7 mm and the thickness of the back-side glass substrate is 3.2 mm. The thicknesses of the glass substrates are, however, not limited to these values. By reducing the thickness of the front-side glass substrate 22 in this way, the thickness and weight of the entire solar battery module 1 can be reduced. Conversely, the thickness of the back-side glass substrate may be reduced in order to reduce the weight of the module.

The sealing member 24 is a thermoplastic sheet-like resin member, and examples of the sealing member 24 that can be used include ethylene-vinyl acetate copolymer, polyvinyl butyral, an olefin-based resin, and a silicone resin. In the present embodiment, an ionomer resin is used. The ionomer resin, which has high fluidity, is an advantageous material as a countermeasure against glass cracking. Specifically, the ionomer resin is easy to handle because it can be held in sheet form at room temperature. It is softened and liquidized at around 100°C and flows without any gaps so as to reliably absorb the thicknesses of enclosures such as wiring during lamination processing. The ionomer resin is thus excellent in adhesion properties.

At the stage before the module is formed into a final article (stage before lamination processing), the sealing member 24 is one size smaller than the outer shapes of the front-side glass substrate 22 and the back-side glass substrate 23 as shown in FIG. 7A. The sealing member 24 has an unevenly shaped portion (hereinafter, referred to as an "uneven portion") 24a on the entire surface on the side facing the solar battery cells 25 (on the underside in FIG. 7A). This uneven portion 24a can be formed by, for example, embossing, but the method for forming the uneven portion is not limited to embossing. While the uneven portion 24a is shaped in inverted triangle (e.g., cone, triangular pyramid, or quadrangular pyramid) form in the present embodiment, the shape is not limited to this. For example, the uneven portion may be shaped in semi-spherical form, semi-ellipse spherical form, cylindrical form, or the like. Briefly, it is sufficient that the uneven portion 24a has a shape that is easy to deform under pressure.

By, in the state shown in FIG. 7A, applying heat under predetermined pressure from above the back-side glass substrate 23 (in the direction indicated by arrows in FIG. 7A) in vacuum conditions, the solar battery module 1 shown in FIG. 7B is produced. Specifically, the solar battery module 1 as a final article is such that the upper face of the sealing member 24 is in intimate contact with the entire lower face of the back-side glass substrate 23, and the lower face of the sealing member 24 with the uneven portion 24a being squeezed and flattened is in intimate contact with the upper faces of the solar battery cells 25 and the upper face of the front-side glass substrate 22 in the periphery of the solar battery cells 25 (i.e., the upper face of the peripheral portion of the front-side glass substrate 22).

Since the sealing member 24 is pressed and extended in the planar direction when the uneven portion 24a is squeezed, a peripheral end face 24b of the sealing member 24 extended in the planar direction is ultimately formed flush with or projecting slightly out in a curved shape from peripheral end faces 22a and 23a of the front-side glass substrate 22 and the back-side glass substrate 23. In FIG. 7B, the peripheral end face 24b is formed projecting out. In other words, the sealing member 24 is configured to also serve to seal the peripheral end face of the solar battery module 1.

This eliminates the need to individually provide a sealing member that seals the solar battery cells and a sealing member that seals the peripheral end faces of the solar battery modules (e.g., a frame member made of aluminum) as in conventional technology, thus making it possible to reduce the number of components and to omit the step of sealing the peripheral end face of the solar battery module in the assembly process. Because the sealing member 24 serves also to seal the peripheral end face of the solar battery module 1, the step of cutting a portion of the sealing member that lies off the module as in conventional technology can also be omitted. Furthermore, if the peripheral end face 24b of the sealing member 24 is formed so as to project out from the peripheral end faces 22a and 23a of the front-side glass substrate 22 and the back-side glass substrate 23, even if a foreign object hits the edge of the solar battery module 1 during and after installation of the solar battery module 1, this object will first hit the peripheral end face 24b of the sealing member 24, and thus the sealing member 24 can serve as a cushioning material and reduce damage to the solar battery module 1.

Moreover, if the peripheral end face 24b of the sealing member 24 is formed flush with or projecting out slightly from the peripheral end faces 22a and 23a of the front-side glass substrate 22 and the back-side glass substrate 23, it is possible to prevent the sealing member 24 in gel from dripping from the peripheral end face 22a of the front-side glass substrate 22 and adhering to a laminating device during manufacture of the solar battery module 1.

Here, in order to harden the ionomer resin forming the sealing member 24, it is necessary to cool the resin for once as well known in conventional technology.

Note that forming the peripheral end face 24b the sealing member 24 flush with or projecting out slightly from the peripheral end faces 22a and 23a of the front-side glass substrate 22 and the back-side glass substrate 23 can be realized by controlling the amounts of pressure and heat applied from above the back-side glass substrate 23.

Incidentally, as shown in FIGS. 7A and 7B, the junction portion (superimposed portion) 38 between the exposed one end portion 33b of the negative lead 33 and the negative drawing line 31 has a shape projecting from the surface of the solar battery cell 25 (i.e., the surface of the back-side electrode layer). Although not shown, the junction portion (superimposed portion) between the exposed one end portion 32b of the positive lead 32 and the positive drawing line 30 similarly has a shape projecting from the surface of the solar battery cell 25 (i.e., the surface of the back-side electrode layer).

If the lower face of the sealing member 24 has a flat shape like the upper face, when predetermined pressure is applied from above the back-side glass substrate 23, the lower face (flat face) of the sealing member 24 first comes in surface-to-surface contact with this projecting junction portion 38 under pressure and is then squeezed while remaining in surface-to-surface contact with the junction portion. Thus, stress is concentrated on the junction portion 38, and in particular, great stress is imposed on a corner portion or the like of the junction portion 38. Such stress affects the front-side glass substrate 22 and the back-side glass substrate 23, and in particular, has great influence on the thickness-reduced front-side glass substrate 22. In other words, a problem arises in that cracking or the like of the front-side glass substrate 22 and the back-side glass substrate 23 is likely to occur in the vicinity of the junction portion 38, including the corner portions, between the positive and negative drawing lines 30 and 31 and the positive and negative leads 32 and 33.

In contrast, in the solar battery module 1 of the present embodiment, when the solar battery cells 25 are sealed with the sealing member 24, the uneven portion 24a of the sealing member 24 first comes in point-to-point contact (or line-to-line contact) with the junction portion 38 between the exposed one end portion 38b of the negative lead 33 and the negative drawing line 31 and is then squeezed from that state so that the sealing member 24 is brought into intimate contact with the back-side electrode layers of the solar battery cells 25. Thus, during sealing, local stress will not be imposed on the front-side glass substrate 22 and the back-side glass substrate 23, including the back-side electrode layers of the solar battery cells 25. In other words, the solar battery module 1 of the present embodiment has a laminated structure in which there is no need to worry about breakage in the front-side glass substrate 22 and the back-side glass substrate 23 due to the application of local stress when the solar battery cells 25 are sealed with the sealing member 24.

The above has been a description of the basic configuration of the solar battery module manufactured by the manufacturing method of the present invention.

Based on the above-described basic configuration, a variety of variations on the solar battery module according to the present invention can be provided. Such variations will now be described below.

### (1) Description of Variation on Sealing Member 24

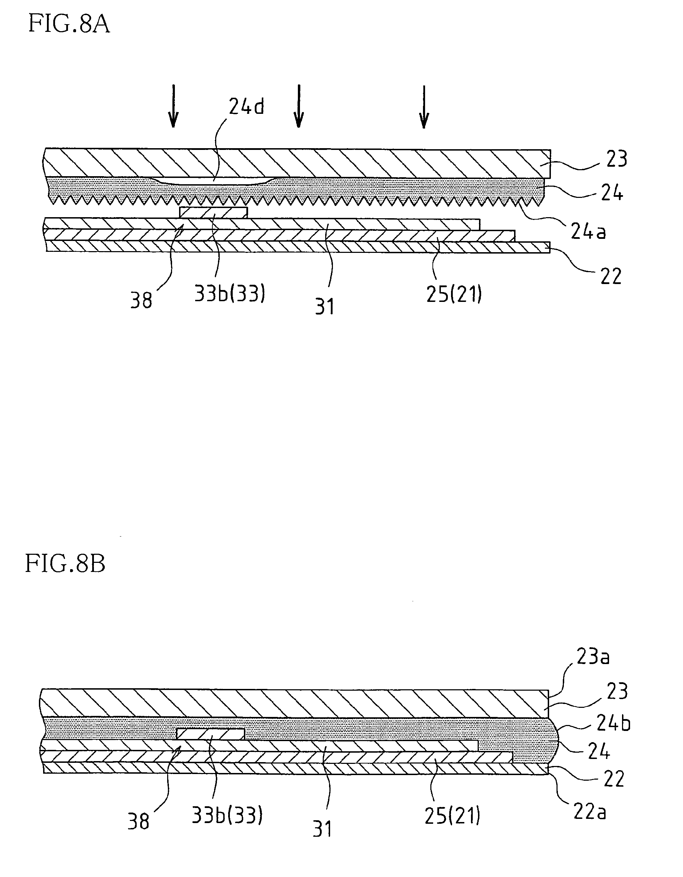

FIGS. 8A and 8B are schematic cross-sectional views of a solar battery module 1 using a sealing member 24 according to a variation. FIG. 8A shows a state of the module before made into a final shape (i.e., before lamination processing), and FIG. 8B shows a state of the module as a final article (i.e., after lamination processing).

Specifically, portions 24d of the sealing member 24 of this variation that face the junction portion 38 (see FIG. 5B) between the positive drawing line 30 and the positive lead 32 and the junction portion 38 between the negative drawing line 31 and the negative lead 33 are formed thinner than the other portion of the sealing member 24. By reducing the thickness of the portions of the sealing member 24 that face peripheral portions that include the junction portions 38 as compared with the thickness of the other portions, it is possible to reduce and disperse stress that is imposed on the sealing member 24 by the junction portions 38 when the sealing member 24 comes in intimate contact with the back-side electrode layer of the solar battery cell 25. Furthermore, by squeezing and deforming the uneven portion 24a of the sealing member 24, it is possible to absorb the amount of thickness of the junction portions 38. As a result, stress that is imposed on the front-side glass substrate 22 and the back-side glass substrate 23 can also be dispersed, and thus it is possible to prevent breakage of the solar battery module 1 due to cracking in the front-side glass substrate 22 and the back-side glass substrate 23. In particular, when the thickness of the front-side glass substrate 22 is reduced in order to reduce the thickness and weight of the module, it becomes an important issue to prevent the occurrence of cracking in the front-side glass substrate 22, but the occurrence of cracking in the front-side glass substrate 22 can be more reliably prevented by reducing the thickness of the sealing member 24 in the peripheral portions that include the junction portions 38 and forming the uneven portion 24a.

Alternatively, although not shown, recessed portions of the uneven portion 24a of the sealing member 24 in areas that face the peripheral portions including the junction portions 38 may be formed deeper than those in the other area, instead of reducing the thickness of the portions of the sealing member 24 that face the peripheral portions including the junction portions 38. As another alternative, the pitch of unevenness in the uneven portion 24a of the sealing member 24 in the areas that face the peripheral portions including the junction portions 38 may be wider than that in the other area. In short, the sealing member 24 may be formed such that the amount of the resin in the portions of the sealing member 24 that face the peripheral portions including the junction portions 38 is smaller than that in portions of the sealing member 24 that face the other portions.

### (2) Description of Variation 1 on Positive/Negative Leads 32, 33

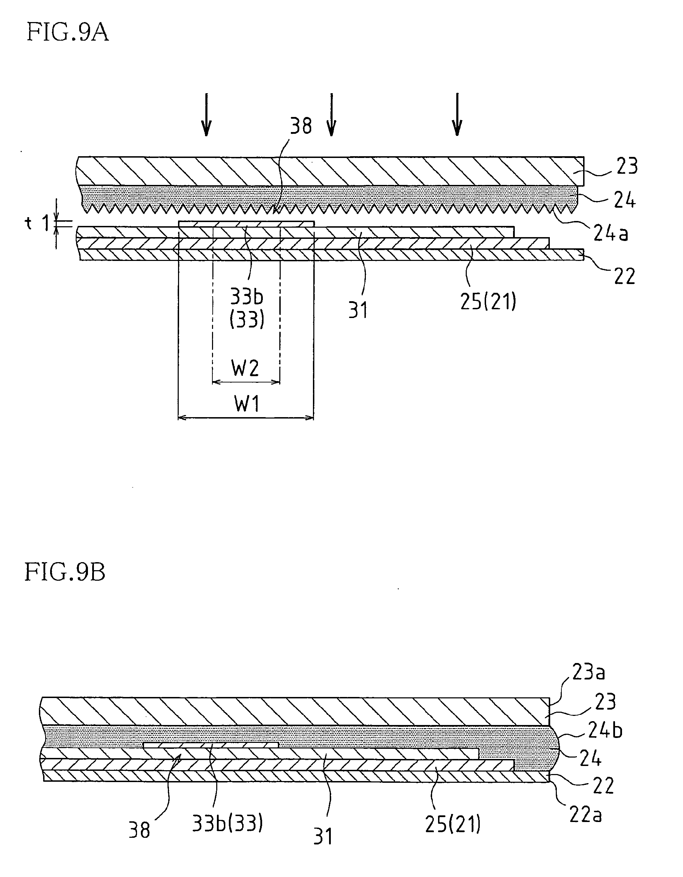

FIGS. 9A and 9B are schematic cross-sectional views of a solar battery module 1 using positive and negative leads 32 and 33 according to Variation 1. FIG. 9A shows a state of the module before made into a final form (i.e., before lamination processing), and FIG. 9B shows a state of the module as a final article (i.e., after lamination processing).

Specifically, the positive and negative leads 32 and 33 according to Variation 1 differ from those in the basic configuration shown in FIGS. 5A, 5B, and the like in that the thickness t1 of the junction portions 38 (i.e., one end portions 32b and 33b) is smaller than the thickness t2 (see FIG. 6) of the other portions of the leads. According to Variation 1, the thickness t1 of the end portions 32b and 33b is one half the thickness t2 of the other portions.

With this configuration, although the junction portions 38 is in a state of projecting by the amount of thickness thereof from the back-side electrode layer, the entire thickness of the junction portions 38 can be reduced to a minimum by reducing the thickness of the end portions 32b and 33b of the positive and negative leads 32 and 33. As a result, it is possible to reduce and disperse the stress that is imposed on the sealing member 24 by the junction portions 38 when the sealing member 24 comes in intimate contact with the back-side electrode layer of the solar battery cell 25 and to thereby disperse the stress that is imposed on the front-side glass substrate 22 and the back-side glass substrate 23. This makes it possible to prevent breakage of the solar battery module 1 due to cracking in the front-side glass substrate 22 and the back-side glass substrate 23. In particular, when the thickness of the front-side glass substrate 22 is reduced in order to reduce the thickness and weight of the solar battery module, it becomes an important issue to prevent cracking in the front-side glass substrate 22, but the occurrence of cracking in the front-side glass substrate 22 can be more effectively prevented by reducing the thickness of the end portions 32b and 33b of the positive and negative leads 32 and 33 in the junction portions 38.

Furthermore, if the configuration of the sealing member 24 according to Variation1 described above is combined in addition to reducing the thickness of the end portions 32b and 33b of the positive and negative leads 32 and 33, it is possible to further reduce and disperse the stress that is imposed on the sealing member 24 by the junction portions 38 when the sealing member 24 comes in intimate contact with the back-side electrode layer of the solar battery cell 25 and to thereby further disperse the stress that is imposed on the front-side glass substrate 22 and the back-side glass substrate 23. Accordingly, breakage of the solar battery module due to cracking in the front-side glass substrate 22 and the back-side glass substrate 23 can be prevented more reliably.

The positive and negative leads 32 and 33 according to Variation 1 also differ from those in the basic configuration shown in FIGS. 5A, 5B, and the like in that a width w1 of the junction portions 38 (i.e., one end portions 32b and 33b) is greater than a width w2 of the other portions. According to Variation 1, the width w1 of the end portions 32b and 33b is two times the width w2 of the other portions. Specifically, the positive and negative leads 32 and 33 are formed such that the cross-sectional area of the end portions 32b and 33b of the leads 32 and 33 along the width thereof is equal to that of the other portions along the width.

Specifically, if only the thickness of one end portions of the leads is reduced, the cross-sectional area of the end portions of the leads along the width becomes smaller than that of the other portions along the width. This increases the resistance of the junction portions 38 and incurs the possibility of heat generation, disconnection, or the like in the junction portions. Thus, according to Variation 1, the width of one end portions of the leads is increased by the amount of thickness that has been reduced, so that the cross-sectional area of one end portions does not become smaller than that of the other portions, and in other words, becomes equal to that of the other portions. As a result, the occurrence of heat generation, disconnection, or the like in the junction portions 38 can be prevented.

### (3) Description of Variation 2 on Positive/Negative Leads 32, 33

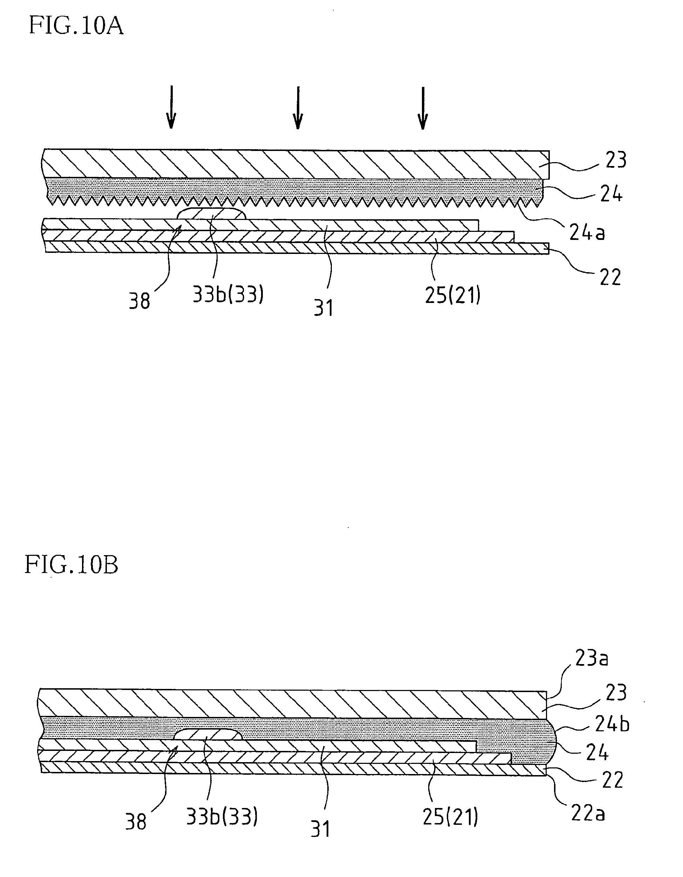

FIGS. 10A and 10B are schematic cross-sectional views of a solar battery module 1 using positive and negative leads 32 and 33 according to Variation 2. FIG. 10A shows a state of the module before made into a final form (i.e., before lamination processing), and FIG. 10B shows a state of the module as a final article (i.e., after lamination processing).

Specifically, the positive and negative leads 32 and 33 according to Variation 2 are formed such that in the cross-sectional shape along the width, corner portions or the entire of the leads along the width are formed in curved shapes. Although not shown, corner portions or the entire of the positive and negative drawing lines 30 and 31 along the width may also be formed in curved shapes in the cross-sectional shapes along the width.

When the cross-sectional shapes of the positive and negative leads 32 and 33 and the drawing lines 30 and 31 along the width are rectangular, stress that is imposed on the sealing member 24 by the positive and negative leads 32 and 33 and the drawing lines 30 and 31 (in particular, the junction portions 38 therebetween) on the back-side electrode layer when the sealing member 24 comes in intimate contact with the back-side electrode layer of the solar battery cell 25 will be concentrated on both corner portions of the positive and negative leads 32 and 33 and the positive and negative drawing lines 30 and 31 across the width. In contrast, according to Variation 2, since the corner portions or the entire of the positive and negative leads 32 and 33 and drawing lines 30 and 31 along the width are formed in curved shapes in the cross-sectional shapes along the width, it is possible to avoid a situation in which stress is concentrated on specific sites of the positive and negative leads 32 and 33 and drawing lines 30 and 31 and to disperse the stress. As a result, it is possible to reduce and disperse the stress that is imposed on the sealing member 24 by the positive and negative leads 32 and 33 and the positive and negative drawing lines 30 and 31 (in particular, the junction portions 38 therebetween) on the back-side electrode layer when the sealing member 24 comes in intimate contact with the back-side electrode layer of the solar battery cell 25, and to thereby disperse the stress that is imposed on the front-side glass substrate 22 and the back-side glass substrate 23. This makes it possible to prevent breakage of the solar battery module 1 due to cracking in the front-side glass substrate 22 and the back-side glass substrate 23. In particular, when the thickness of the front-side glass substrate 22 is reduced in order to reduce the thickness and weight of the solar battery module, it becomes an important issue to prevent the occurrence of cracking in the front-side glass substrate 22, but the occurrence of cracking in the front-side glass substrate 22 can be more effectively prevented by forming the corner portions or the entire of the positive and negative leads 32 and 33 and the positive and negative drawing lines 30 and 31 along the width in curved shapes in the cross-sectional shapes along the width. With respect to the positive and negative leads 32 and 33, the occurrence of cracking in the front-side glass substrate 22 can be yet more effectively prevented by combining Variation 1 and Variation 2 described above.

### (4) Description of Variation on Shape of Peripheral Edge Portion of Front-Side Glass Substrate 22

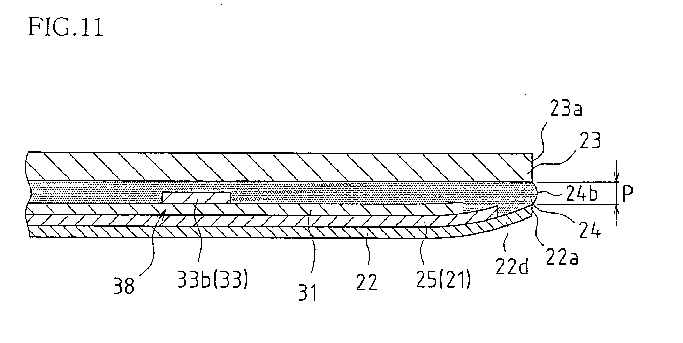

FIG. 11 is a partial enlarged schematic cross-sectional view showing the shape of the termination portion of a solar battery module 1.

In the solar battery module 1 shown in FIG. 11, the vicinity 22d of the peripheral edge portion of a front-side glass substrate 22 is curved toward a back-side glass substrate 23.

Specifically, the front-side glass substrate 22 is formed thinner than the back-side glass substrate 23. The solar battery module 1 has outer dimensions of approximately 1400 mm longitudinally and 1000 mm laterally and is large in scale. Accordingly, the dimensions of the front-side glass substrate 22 and the back-side glass substrate 23 also conform to these outer dimensions. That is, the thin and large-scale front-side glass substrate 22 in itself is easy to curve. Thus, in the present invention, this characteristic of the front-side glass substrate 22 is used to form the front-side glass substrate 22 such that the vicinity 22d of the Peripheral edge portion of the front-side glass substrate 22 is curved toward the back-side glass substrate 23 when solar battery cells 25 are sealed with a sealing member 24 between the front-side glass substrate 22 and the back-side glass substrate 23. Forming the front-side glass substrate 22 in this way narrows a gap P between the peripheral edge portions of the front-side glass substrate 22 and the back-side glass substrate 23 and reduces the area of a peripheral end face 24b of the sealing member 24 that is exposed to the peripheral end face of the solar battery module 1. As a result, it is possible to more effectively prevent the entry of water vapor or the like from the peripheral end face of the solar battery module 1 after installation of the solar battery module 1.

(5) Lastly, the method for manufacturing the solar battery modules 1 with the above-described configurations will be collectively described again. Note, the manufacturing method will be described with reference to the basic configurations shown in FIGS. 5A, 5B, 6, 7A, and 7B.

First, a plurality of solar battery cells 25 are formed on the front-side glass substrate 22.

Specifically, as have already been described with reference to FIGS. 5A and 5B, a plurality of solar battery cells 25 are formed on the front-side glass substrate 22, and each pair of adjacent solar battery cells 25 are arranged such that the front-side electrode layer of one solar battery cell and the back-side electrode layer of the other solar battery cell are connected to each other, forming a solar battery string 26 in which the plurality of solar battery cells 25 are connected in series. Then, a P-type electrode terminal portion 27 is formed on the solar battery cell 25 located at one edge of the solar battery string 26, an N-type electrode terminal portion 28 is formed on the edge portion of the back-side electrode layer of the solar battery cell 25 located at the other edge, a positive drawing line 30 is bonded to the P-type electrode terminal portion 27, and a negative drawing line 31 is bonded to the N-type electrode terminal portion 28. After this, a positive lead 32 and a negative lead 33, one side of each being coated with an insulation film 36, are linearly disposed on the solar battery string 26 with their tip ends facing each other. Then, one end portion 32b of the positive lead 32 that is exposed is connected to the positive drawing line 30 by soldering, and one end portion 33b of the negative lead 33 that is exposed is connected to the negative drawing line 31 by soldering.

Next, as shown in FIG. 7A, the sealing member 24 is disposed on the front-side glass substrate 22 on which the plurality of solar battery cells 25 are formed, such that the uneven portion 24a of the sealing member 24 is on the side facing the solar battery cells 25. Then, the back-side glass substrate 23 is disposed on the sealing member 24.

Next, lamination processing in which heat is applied under pressure from above the back-side glass substrate 23 is performed in vacuum conditions. Specifically, when the heating has progressed to some extent, the sealing member 24 has reduced viscosity and exhibits fluidity. As a result, the uneven portion 24a that is in contact with the back-side electrode layer of the solar battery cells 25 is gradually squeezed and extended in the planar direction, and the sealing member 24 approaches the front-side glass substrate 22. When the heating has further progressed and reached a termination stage of the laminate processing, the sealing member 24 melts and flows without any gap throughout and the vicinity of the entire back-side electrode layer of the solar battery cell 25 and is thereafter cooled (reduced in temperature) for once and hardened. As a result, the solar battery module 1 having the configuration shown in FIG. 7B is manufactured.

In the present embodiment, since the sealing member 24 is formed of an ionomer resin, the sealing member 24 molten by the application of heat is easy to deform, and the uneven portion 24a can be evenly squeezed by being extended in the planar direction. Finally, the uneven portion 24a is completely squeezed so that the sealing member 24 is evenly in contact with the entire back-side electrode layer of the solar battery cells 25, the upper face of the peripheral edge portion of the front-side glass substrate 22 that lies off the solar battery cells 25, and the entire opposing lower face of the back-side glass substrate. In this lamination processing, when pressure is applied to the sealing member 24 via the back-side glass substrate 23, the uneven portion 24a of the sealing member 24 is substantially evenly squeezed, and thus the resultant stress is substantially evenly imposed on the entire back-side glass substrate 23 and the entire front-side glass substrate 22 and will not be concentrated on specific sites. This in particular makes it possible to prevent or reduce breakage such as cracking in the thickness-reduced front-side glass substrate 22.

While the amount of pressure applied to the sealing member 24 during the lamination processing is constant in the above-described manufacturing method, it may be increased in stages. In this case, lamination processing may be performed such that after the stage of heating and melting the sealing member 24 is performed by the application of low pressure to the back-side glass substrate 23, high pressure is applied to the back-side glass substrate 23 so as to squeeze the sealing member 24. If from the very beginning, high pressure is applied to the back-side glass substrate 23, there is a possibility of cracking in the thin front-side glass substrate 22. However, this possibility can be reduced by increasing the amount of pressure applied in stages.

Note that the above embodiment describes a case in which the front-side glass substrate 22 is formed thinner than the back-side glass substrate 23, the manufacturing method of the present invention is also applicable to a solar battery module in which the back-side glass substrate 23 is formed thinner than the front-side glass substrate 22, opposite to the way described above.

Also, while the above-described embodiment describes the case in which solar battery modules manufactured by the manufacturing method of the present invention are applied to a photovoltaic power generating system in which the solar battery modules are placed on a mounting, and the solar battery modules 1 are each provided with the two support members 19 that serve also as the mounting brackets to the mounting 10, it goes without saying that the present invention is also applicable to a solar battery module that is not provided with such support members 19.

The present invention can be reduced to practice in various other forms without departing from its spirit or essential features. For this reason, the above-described exemplary embodiments are to all intents and purposes merely illustrative and should not be construed as limiting. The scope of the present invention is defined by the claims and is not in any way restricted by the descriptions of the specification. Furthermore, all variations within the meaning and range of equivalency of the claims fall within the scope of the present invention.

Also, this application claims prior right on the basis of Japanese Patent Application No. 2010-149308 filed in Japan on June 30, 2010, the content of which is hereby incorporated in its entirety by reference herein.

### Industrial Applicability

The present invention is useful in terms of being able to provide a method for manufacturing a solar battery module that causes less breakage in the front-side glass substrate, the back-side glass substrate, or the like and exhibits excellent water resistance even if a thickness-reduced front-side glass substrate (or thickness-reduced back-side glass substrate) is employed in order to reduce the thickness and weight of a resin sealing type solar battery module having a laminated glass structure, and to provide a solar battery module manufactured by the manufacturing method.

### Description of Reference Numerals

| | |
|---|---|
| 1 | Solar battery module |
| 10 | Mounting |
| 11 | Concrete foundation |
| 12 | Base bar |
| 13 | Arm |
| 14 | Longitudinal bar |
| 15 | Lateral bar |
| 17 | Guide support member |
| 18 | Double-faced tape |
| 19 | Support member |
| 19e | Engaging portion |
| 21 | Semiconductor layer portion |
| 22 | Front-side glass substrate (front-side insulation substrate) |
| 23 | Back-side glass substrate (back-side insulation substrate) |
| 23a, 23a | Peripheral end face |
| 24 | Sealing member |
| 24a | Uneven portion |
| 24b | Peripheral end face |
| 25 | Solar battery cell (front-side electrode layer, photoelectric conversion layer, back-side electrode layer) |
| 26 | Solar battery string |
| 27 | P-type electrode terminal portion |
| 28 | N-type electrode terminal portion |
| 30 | Positive drawing line |
| 31 | Negative drawing line |
| 32 | Positive lead |
| 33 | Negative lead |
| 32a, 32b | Output lead portion |
| 32b, 33b | One end portion |
| 36 | Insulation film |
| 38 | Junction portion |

## Claims

1. A method for manufacturing a solar battery module having a laminated glass structure in which an insulation substrate on one side has a reduced thickness, comprising the steps of
forming a solar battery cell on a front-side insulation substrate; disposing a sealing member on the front-side insulation substrate on which the solar battery cell is formed, the sealing member having a shape smaller than outer shapes of the front-side insulation substrate and a back-side insulation substrate and having an uneven shape on a side that faces the solar battery cell;
disposing the back-side insulation substrate on the sealing member; sealing the solar battery cell between the front-side insulation substrate and the back-side insulation substrate by applying heat under pressure from above the back-side insulation substrate in vacuum conditions so as to squeeze the uneven portion of the sealing member and bring the sealing member into intimate contact with the solar battery cell; and
cooling and thereby hardening the sealing member,
wherein the sealing member is an ionomer resin.

2. The method for manufacturing a solar battery module according to claim 1, wherein the sealing member is formed such that after hardening, a peripheral end face of the sealing member is flush with or projects out from peripheral end faces of the front-side insulation substrate and the back-side insulation substrate.

3. The method for manufacturing a solar battery module according to claim 1 or 2, wherein
a drawing line for drawing current and a lead for outputting current from the drawing line to an exterior are disposed on the back-side electrode layer of the solar battery cell, and
the sealing member in a portion that faces a junction portion between the drawing line and the lead is formed thinner than in the other portion.

4. The method for manufacturing a solar battery module according to any one of claims 1 to 3, wherein the lead is formed so as to have a smaller thickness in the junction portion than in the other portion.

5. The method for manufacturing a solar battery module according to claim 4, wherein the lead is formed so as to have a greater width in the junction portion than in the other portion.

6. The method for manufacturing a solar battery module according to claim 5, wherein the thickness and width of the lead are set such that a cross-sectional area of the lead along the width in the junction portion is equal to a cross-sectional area of the lead along the width in the other portion.

7. The method for manufacturing a solar battery module according to any one of claims 3 to 6, wherein in a cross-sectional shape of the lead and/or the drawing line along the width thereof, a corner portion or the entire of the lead and/or the drawing line along the width is formed in a curved shape.

8. A solar battery module having a laminated glass structure in which an insulation substrate on one side has a reduced thickness and being configured such that a solar battery cell is formed on a front-side insulation substrate and a sealing member is disposed between the solar battery cell and a back-side insulation substrate,
wherein a vicinity of a peripheral edge portion of the thinner insulation substrate is curved toward the thicker insulation substrate.

9. A solar battery module manufactured by the manufacturing method according to any one of claims 1 to 7, wherein a peripheral end face of the sealing member is formed flush with or projecting out from peripheral end faces of the front-side insulation substrate and the back-side insulation substrate.
